# EUROPEAN PATENT APPLICATION

(11) **EP 3 926 799 A1**
(43) Date of publication of application: **22.12.2021**
(21) Application number: 20919359.8
(22) Date of filing: 06.07.2020
(51) Int. Cl.: H02M 1/00

(54) **SWITCHING FREQUENCY JITTERING METHOD, SWITCHING CIRCUIT, AND DC-DC CONVERTER**

(30) Priority: 05.07.2020 CN 202010637707
(71) Applicant: SHANGHAI WEIZIMEI ELECTRONIC TECHNOLOGY CO., LTD, Shanghai 201203 (CN)
(72) Inventor: LI, Yushan, Shanghai 201210 (CN)
(74) Representative: Bandpay & Greuter
(86) International application number: PCT/CN2020/100507
(87) International publication number: WO 2021/212664

(57) **Abstract**

Embodiments of the present application disclose a switching frequency dithering method, a switching circuit and a DC-DC converter. A switching frequency in the switching frequency dithering method disclosed in the embodiments of the present application dithers up and down at a third switching frequency or between randomly generated target switching frequencies. The sembodiments of the present application further provide a switching circuit and a DC-DC converter, which can be used to control a clock signal and optimize comprehensive system performance such as improving system efficiency, reducing noise and ripple, suppressing switching harmonics, and reducing electromagnetic radiation.

## Description

### TECHNICAL FIELD

Embodiments of the present application relate to the field of switching frequency dithering techniques, and in particular, to a switching frequency dithering method, a switching circuit and a DC-DC converter.

### BACKGROUND

In many applications, switching frequencies need to be dithered to achieve spectrum spreading to reduce noise and ripple, suppress switching harmonics and reduce electromagnetic radiation.

In the prior art, a triangular frequency dithering method is a commonly-used switching frequency dithering method in which frequencies linearly change between fixed maximum and minimum values. Although the ripple generated in triangular frequency dithering is relatively small, suppression effects of switching harmonics are limited.

A pseudo-random binary sequence is used in another commonly-used switching frequency dithering method in which switching frequencies change in accordance with the pseudo-random binary sequence. The pseudo-random binary sequence may be generated by a linear feedback shift register. Although the pseudo-random binary sequence-based dithering method can effectively suppress switching harmonics, it generates relatively large ripple.

Patent No. US 9166471 discloses a dithering method that combines both triangular frequency dithering and pseudo-random binary sequence-based dithering. While reducing the ripple, the method also suppresses switching harmonics, but this technical solution does not optimize comprehensive system performance such as improving system efficiency, reducing noise and ripple, suppressing switching harmonics, and reducing electromagnetic radiation.

### SUMMARY

Embodiments of the present application disclose a switching frequency dithering method, a switching circuit and a DC-DC converter, to optimize comprehensive system performance such as improving system efficiency, reducing noise and ripple, suppressing switching harmonics, and reducing electromagnetic radiation.

According to a first aspect of the present application, the dithering method is used to control a clock frequency change, and includes:
setting a first switching frequency, a second switching frequency and a third switching frequency therebetween;
setting an initial switching frequency and generating the first pseudo-random number at the beginning of a series of clock cycles; determining the first target switching frequency for switching frequency adjustment based on the first pseudo-random number, and adjusting the switching frequency to gradually change from the initial switching frequency to the first target switching frequency, and then gradually change from the first target switching frequency to the third switching frequency;
generating an N^{th} pseudo-random number, and determining an N^{th} target switching frequency for switching frequency adjustment based on the N^{th} pseudo-random number;
comparing the N^{th} target switching frequency with the third switching frequency; and
adjusting the switching frequency to gradually change from the third switching frequency to the N^{th} target switching frequency according to a comparison result, and then gradually change from the N^{th} target switching frequency to the third switching frequency, where the first target switching frequency and the N^{th} target switching frequency are between the first switching frequency and the second switching frequency, and are not equal to the third switching frequency, where N is a natural number starting from 2.

According to the first aspect of the embodiments of the present application, the switching frequency changes linearly up and down at the third switching frequency based on the target switching frequency randomly generated at the beginning of the series of clock cycles, and the switching frequency change is relatively small. Therefore, the switching frequency dithering method disclosed in the embodiments of the present application optimizes comprehensive system performance such as improving system efficiency, reducing noise and ripple, suppressing switching harmonics, and reducing electromagnetic radiation.

According to a second aspect of embodiments of the present application, the dithering method is used to control a clock frequency change, and includes:
setting a first switching frequency and a second switching frequency;
setting an initial switching frequency and generating the first pseudo-random number at the beginning of a series of clock cycles; determining the first target switching frequency for switching frequency adjustment based on the first pseudo-random number, and adjusting the switching frequency to gradually change from the initial switching frequency to the first target switching frequency;
generating an N^{th} pseudo-random number, and determining an N^{th} target switching frequency for switching frequency adjustment based on the N^{th} pseudo-random number;
comparing the N^{th} target switching frequency with an (N-1)^{th} target switching frequency, where the (N-1)^{th} target switching frequency is determined by an (N-1)^{th} pseudo-random number generated randomly; and
adjusting the switching frequency to gradually change from the (N-1)^{th} target switching frequency to the N^{th} target switching frequency according to a comparison result, where the (N-1)^{th} target switching frequency and the N^{th} target switching frequency are between the first switching frequency and the second switching frequency, and N is a natural number starting from 2.

According to the second aspect of the embodiments of the present application, the switching frequency changes linearly between target switching frequencies randomly generated at the beginning of the series of clock cycles, and the switching frequency change is relatively small. Therefore, the switching frequency dithering method disclosed in the embodiments of the present application optimizes comprehensive system performance such as improving system efficiency, reducing noise and ripple, suppressing switching harmonics, and reducing electromagnetic radiation.

According to a third aspect of the embodiments of the present application, the embodiments of the present application disclose a switching circuit, where the circuit is configured to control a clock frequency change and includes: a control circuit and an oscillation circuit; where
the control circuit is configured to set a first switching frequency, a second switching frequency and a third switching frequency therebetween;
set an initial switching frequency and generate the first pseudo-random number at the beginning of a series of clock cycles; determine the first target switching frequency for switching frequency adjustment based on the first pseudo-random number, and adjust the switching frequency to gradually change from the initial switching frequency to the first target switching frequency, and then gradually change from the first target switching frequency to the third switching frequency;
configured to generate an N^{th} pseudo-random number, and determine an N^{th} target switching frequency for switching frequency adjustment based on the N^{th} pseudo-random number;
configured to compare the N^{th} target switching frequency with the third switching frequency; and
configured to adjust the switching frequency to gradually change from the third switching frequency to the N^{th} target switching frequency according to a comparison result, and then gradually change from the N^{th} target switching frequency to the third switching frequency, where the first target switching frequency and the N^{th} target switching frequency are between the first switching frequency and the second switching frequency, and are not equal to the third switching frequency, where N is a natural number starting from 2; and
the oscillation circuit is configured to receive a switching frequency digital signal output by the control circuit and convert the same into a clock signal with a determined switching frequency.

The beneficial effects of the switching circuit disclosed in the third aspect of the embodiments of the present application are the same as those of the technical solutions disclosed in the first aspect of the embodiments of the present application, and are not described herein again.

According to a fourth aspect of the present application, the embodiments of the present application disclose a switching circuit, where the circuit is configured to control a clock frequency change and includes: a control circuit and an oscillation circuit; where
the control circuit is configured to set a first switching frequency and a second switching frequency;
configured to: set an initial switching frequency and generate the first pseudo-random number at the beginning of a series of clock cycles; determine the first target switching frequency for switching frequency adjustment based on the first pseudo-random number, and adjust the switching frequency to gradually change from the initial switching frequency to the first target switching frequency;
configured to generate an N^{th} pseudo-random number, and determine an N^{th} target switching frequency for switching frequency adjustment based on the N^{th} pseudo-random number;
configured to compare the N^{th} target switching frequency with an (N-1)^{th} target switching frequency, where the (N-1)^{th} target switching frequency is determined by an (N-1)^{th} pseudo-random number generated randomly; and
configured to adjust the switching frequency to gradually change from the (N-1)^{th} target switching frequency to the N^{th} target switching frequency according to a comparison result, where the (N-1)^{th} target switching frequency and the N^{th} target switching frequency are between the first switching frequency and the second switching frequency, and N is a natural number starting from 2; and
the oscillation circuit is configured to receive a switching frequency digital signal output by the control circuit and convert the same into a clock signal with a determined switching frequency.

The beneficial effects of the switching circuit disclosed in the fourth aspect of the embodiments of the present application are the same as those of the technical solutions disclosed in the second aspect of the embodiments of the present application, and are not described herein again.

According to a fifth aspect of the present application, the embodiments of the present application disclose a DC-DC converter, where the DC-DC converter includes the switching circuit according to any one of the technical solutions of the third aspect or the fourth aspect.

According to the fifth aspect of the embodiments of the present application, the embodiments of the present application disclose the DC-DC converter. The beneficial effects of the DC-DC converter are the same as those of any one of the technical solutions of the first aspect and the third aspect or the second aspect and the fourth aspect, and are not described herein again.

It should be noted that more applications and advantages of the switching frequency dithering method, the switching circuit and the DC-DC converter provided by the embodiments of the present application will be apparent from the following detailed description.

### BRIEF DESCRIPTION OF DRAWINGS

The accompanying drawings described herein are intended to provide a further understanding of the present application, and constitute a part of the present application. The illustrative embodiments of the present application and descriptions thereof are intended to describe the present application, and do not constitute improper limitations on the present application. In the accompanying drawings:
FIG. 1 is a schematic diagram illustrating switching frequency dithering in which triangular and pseudo-random binary sequences are mixed in the prior art;
FIG. 2 is a schematic flowchart illustrating a switching frequency dithering method according to a first aspect of an embodiment of the present application;
FIG. 3 is a schematic diagram illustrating switching frequency dithering in accordance with a randomly generated switching frequency according to the first aspect of an embodiment of the present application;
FIG. 4 is a schematic flowchart illustrating a switching frequency dithering method according to a second aspect of an embodiment of the present application;
FIG. 5 is a schematic diagram illustrating switching frequency dithering in accordance with a randomly generated switching frequency according to the second aspect of an embodiment of the present application;
FIG. 6 is a structural block diagram illustrating a switching circuit disclosed in a third aspect of an embodiment of the present application;
FIG. 7 is a structural block diagram illustrating a control circuit shown in FIG. 6;
FIG. 8 is a structural block diagram illustrating a switching circuit disclosed in a fourth aspect of an embodiment of the present application;
FIG. 9 is a structural block diagram illustrating a control circuit shown in FIG. 8; and
FIG. 10 is a schematic diagram illustrating a pseudo-random binary sequence generated by a linear feedback shift register according to an embodiment of the present application.

### DESCRIPTION OF EMBODIMENTS

To make the objects, technical solutions, and advantages of the present application clearer, the following clearly and completely describes the technical solutions of the present application with reference to specific embodiments and accompanying drawings of the present application. Apparently, the described embodiments are merely some rather than all of the embodiments of the present application. All other embodiments obtained by a person of ordinary skill in the art based on the embodiments of the present application without creative efforts shall fall within the protection scope of the present application.

It should be noted that in the specification, claims, and accompanying drawings of the present application, the terms "first", "second", and so on are intended to distinguish between similar objects, but do not necessarily indicate a specific order or sequence. It should be understood that the terms used in such a way are interchangeable in appropriate circumstances so that the embodiments of the present application described herein can be implemented in an order other than the order illustrated or described herein.

The technical solutions provided in the embodiments of the present application are described in detail below with reference to the accompanying drawings.

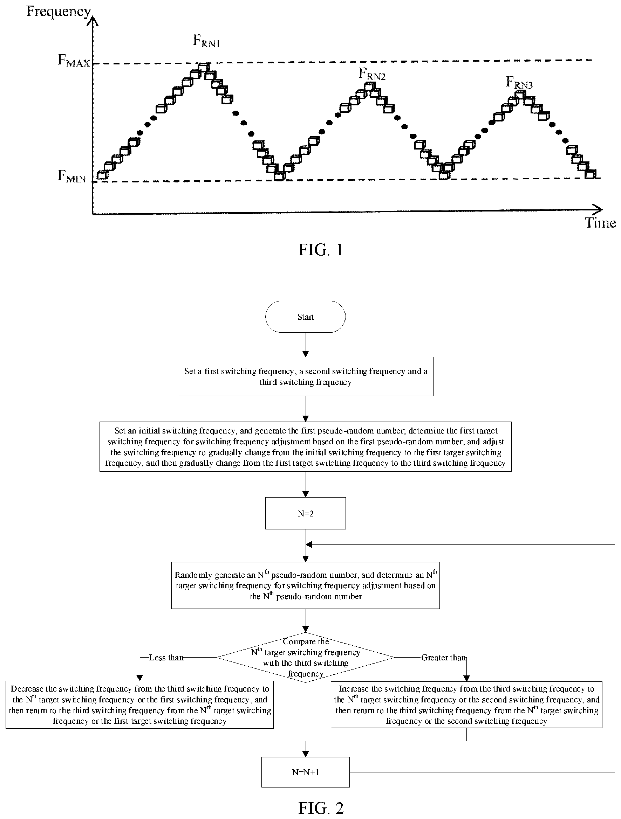

FIG. 1 is a schematic diagram illustrating switching frequency dithering in which triangular and pseudo-random binary sequences are mixed in the prior art.

In the prior art, at the beginning of a series of clock cycles, a pseudo-random number is generated, a maximum switching frequency for switching frequency adjustment is determined based on the pseudo-random number, so that the switching frequency is adjusted to increase from a fixed minimum switching frequency to the maximum switching frequency, and then decrease from the maximum switching frequency to the fixed minimum switching frequency, and the switching frequency always dithers between the fixed minimum switching frequency and the randomly generated maximum switching frequency. Although the prior art suppresses switching harmonics while reducing ripple, this technical solution does not optimize comprehensive system performance such as improving system efficiency, reducing noise and ripple, suppressing switching harmonics, and reducing electromagnetic radiation.

Compared with FIG. 1 that is the schematic diagram illustrating switching frequency dithering in which triangular and pseudo-random binary sequences are mixed,

FIG. 2 to FIG. 5 describe two implementations of a switching frequency dithering method disclosed in the present application.

According to a first aspect, a switching frequency dithering method disclosed in an embodiment of the present application is used to control a clock frequency change in a DC-DC converter. The switching frequency dithering method disclosed in the embodiment of the present application optimizes comprehensive system performance such as improving system efficiency, reducing noise and ripple, suppressing switching harmonics, and reducing electromagnetic radiation.

FIG. 2 is a schematic flowchart illustrating a switching frequency dithering method according to a first aspect of an embodiment of the present application.

A first switching frequency is set to F_{MIN}, a second switching frequency is set to F_{MAX}, and a third switching frequency between the two switching frequencies is set to F_{CENTER}, where the first switching frequency is less than the second switching frequency, and the third switching frequency is between the first switching frequency and the second switching frequency; and the third switching frequency is obtained based on comprehensive optimization of efficiency, noise, and other performance parameters of an entire system. In the embodiment of the present application, the third switching frequency is at or not at the frequency center position between first switching frequency and the second switching frequency, which is not limited in the embodiment of the present application.

Since the DC-DC converter undergoes frequent frequency switching when switching signals, to optimize comprehensive system performance such as improving system efficiency, reducing noise and ripple, suppressing switching harmonics, and reducing electromagnetic radiation, an initial switching frequency is set and the first pseudo-random number is generated at the beginning of a series of clock cycles; the first target switching frequency for switching frequency adjustment is determined based on the first pseudo-random number, and the switching frequency is adjusted to gradually change from the initial switching frequency to the first target switching frequency, and then gradually change from the first target switching frequency to the third switching frequency; then, an N^{th} pseudo-random number is randomly generated, and an N^{th} target switching frequency for switching frequency adjustment is determined based on the N^{th} pseudo-random number, where the initial switching frequency may be a randomly generated frequency or a set fixed frequency. The set fixed frequency may be equal to or different from the third switching frequency and is between the first switching frequency and the second switching frequency.

When the N^{th} target switching frequency is less than the third switching frequency, the switching frequency is adjusted to decrease from the third switching frequency to the N^{th} target switching frequency, and then gradually return to the third switching frequency, i.e., the N^{th} target switching frequency is obtained by gradually decreasing from the third switching frequency by the pseudo-random number.

When the N^{th} target switching frequency is greater than the third switching frequency, the switching frequency is adjusted to increase from the third switching frequency to the N^{th} target switching frequency, and then gradually return to the third switching frequency, i.e., the N^{th} target switching frequency is obtained by gradually increasing from the third switching frequency by the pseudo-random number.

When the switching frequency is close to the third switching frequency, an (N+1)^{th} pseudo-random number is then randomly generated, an (N+1)^{th} target switching frequency for switching frequency adjustment is determined based on the (N+1)^{th} pseudo-random number, and a dithering direction of the switching frequency is determined based on whether the (N+1)^{th} target switching frequency is greater than the third switching frequency. The above-mentioned process is repeated. In this embodiment, the first target switching frequency, the N^{th} target switching frequency, and the (N+1)^{th} target switching frequency are between the first switching frequency and the second switching frequency, and are not equal to the third switching frequency, where N is a natural number starting from 2.

In the embodiment of the present application, the switching frequency is adjusted via linear stepping.

According to the first aspect of the embodiment of the present application, at the beginning of the series of clock cycles, the switching frequency changes linearly up and down at the third switching frequency based on a target switching frequency randomly generated every time, and the switching frequency change is relatively small. Therefore, the switching frequency dithering method disclosed in the embodiment of the present application optimizes comprehensive system performance such as improving system efficiency, reducing noise and ripple, suppressing switching harmonics, and reducing electromagnetic radiation.

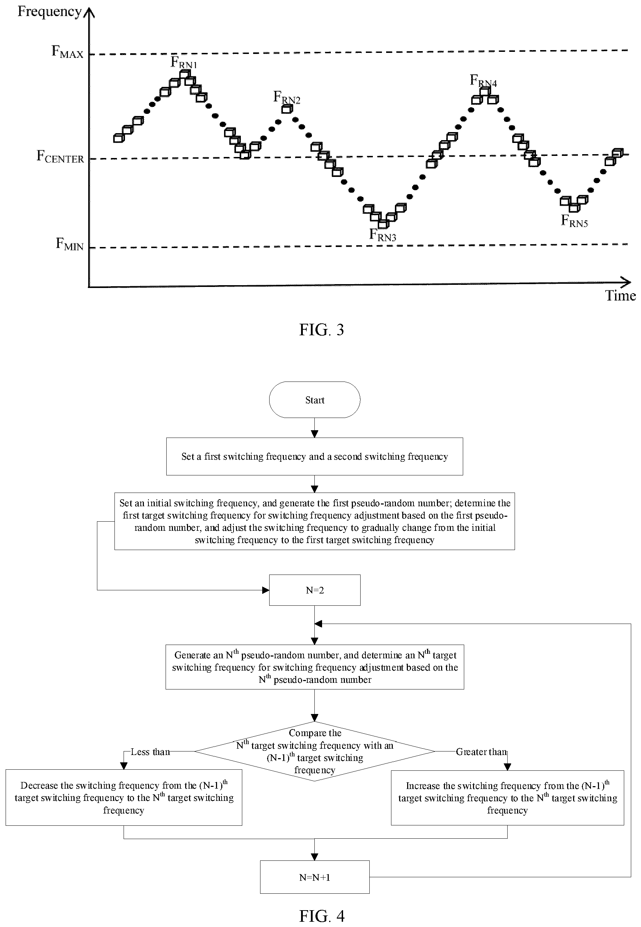

FIG. 3 is a schematic diagram illustrating switching frequency dithering in accordance with a randomly generated target switching frequency according to the first aspect of an embodiment of the present application.

FIG. 3 shows that the first target switching frequency to the fifth target switching frequency F_{RN1}, F_{RN2}, F_{RN3}, F_{RN4}, and F_{RN5} are randomly generated, which are separately between the first switching frequency F_{MIN} and the second switching frequency F_{MAX}, and change up and down at the third switching frequency. When the switching frequency sequentially reaches the first target switching frequency to the fifth target switching frequency, the switching frequency will linearly return to the third switching frequency.

According to a second aspect, a switching frequency dithering method provided in an embodiment of the present application is applied in a DC-DC converter and used to control a clock frequency change. The switching frequency dithering method disclosed in the embodiment of the present application optimizes comprehensive system performance such as improving system efficiency, reducing noise and ripple, suppressing switching harmonics, and reducing electromagnetic radiation.

FIG. 4 is a schematic flowchart illustrating a switching frequency dithering method according to a second aspect of an embodiment of the present application.

A first switching frequency F_{MIN} and a second switching frequency F_{MAX} are set, where the first switching frequency is less than the second switching frequency.

At the beginning of a series of clock cycles, an initial switching frequency is set, and the first pseudo-random number is generated; the first target switching frequency for switching frequency adjustment is determined based on the first pseudo-random number, and the switching frequency is adjusted to gradually change from the initial switching frequency to the first target switching frequency; then, an N^{th} pseudo-random number is generated, and an N^{th} target switching frequency for switching frequency adjustment is determined based on the N^{th} pseudo-random number, where the initial switching frequency may be a randomly generated frequency or a set frequency. The set frequency is between the first switching frequency and the second switching frequency.

When the N^{th} target switching frequency is greater than an (N-1)^{th} target switching frequency, the switching frequency is adjusted to increase from the (N-1)^{th} target switching frequency to the N^{th} target switching frequency, i.e., the N^{th} target switching frequency is obtained by gradually increasing from the (N-1)^{th} target switching frequency by the pseudo-random number.

When the N^{th} target switching frequency is less than the (N-1)^{th} target switching frequency, the switching frequency is adjusted to decrease from the (N-1)^{th} target switching frequency to the N^{th} target switching frequency, i.e., the N^{th} target switching frequency is obtained by gradually decreasing from the (N-1)^{th} target switching frequency by the pseudo-random number.

When the switching frequency is close to the N^{th} target switching frequency, an (N+1)^{th} pseudo-random number is then randomly generated, an (N+1)^{th} target switching frequency for switching frequency adjustment is determined based on the (N+1)^{th} pseudo-random number, and a dithering direction of the switching frequency is determined based on a result of comparing the (N+1)^{th} target switching frequency with the N^{th} target switching frequency. The above-mentioned process is repeated.

The (N-1)^{th} target switching frequency, the N^{th} target switching frequency and the (N+1)^{th} target switching frequency are between the first switching frequency and the second switching frequency, and the N^{th} target switching frequency is determined by the N^{th} pseudo-random number generated randomly, where N is a natural number starting from 2.

In the embodiment of the present application, the switching frequency is adjusted via linear stepping.

According to the second aspect of the embodiment of the present application, at the beginning of the series of clock cycles, the switching frequency dithers linearly between target switching frequencies randomly generated every time, and the switching frequency change is relatively small. Therefore, the switching frequency dithering method disclosed in the embodiment of the present application optimizes comprehensive system performance such as improving system efficiency, reducing noise and ripple, suppressing switching harmonics, and reducing electromagnetic radiation.

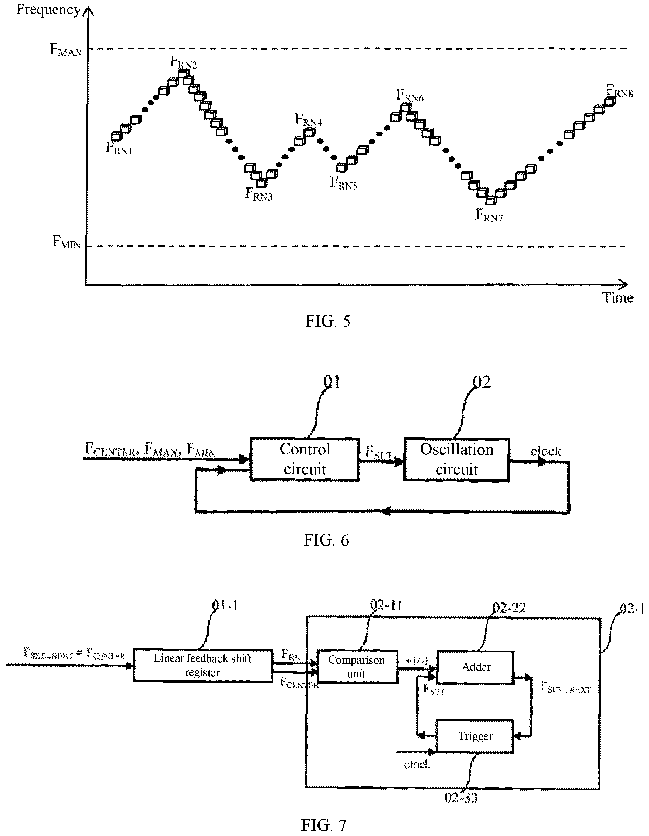

FIG. 5 is a schematic diagram illustrating a switching frequency change in accordance with a randomly generated target switching frequency according to the first aspect of an embodiment of the present application.

FIG. 5 shows that the generated first target switching frequency to eighth target switching frequency F_{RN1}, F_{RN2}, F_{RN3}, F_{RN4}, F_{RN5}, F_{RN6}, F_{RN7} and F_{RN8} are between the second switching frequency and the first switching frequency, and after the switching frequency sequentially reaches the first target switching frequency to the eighth target switching frequency, the dithering direction of the switching frequency is determined based on a randomly generated target switching frequency and the previous target switching frequency.

According to a third aspect, FIG. 6 is a structural block diagram illustrating a switching circuit disclosed in an embodiment of the present application.

The switching circuit is configured to control a clock frequency change and includes a control circuit 01 and an oscillation circuit 02, where the control circuit 01 is connected to the oscillation circuit 02.

The control circuit 01 is configured to: set an initial switching frequency and generate the first pseudo-random number at the beginning of a series of clock cycles according to a first switching frequency F_{MIN}, a second switching frequency F_{MAX} and a third switching frequency F_{CENTRE} therebetween; determine the first target switching frequency for switching frequency adjustment based on the first pseudo-random number, and adjust the switching frequency to gradually change from the initial switching frequency to the first target switching frequency, and then gradually change from the first target switching frequency to the third switching frequency; then, randomly generate an N^{th} pseudo-random number, and determine an N^{th} target switching frequency for switching frequency adjustment based on the N^{th} pseudo-random number; compare the N^{th} target switching frequency with the third switching frequency; adjust the switching frequency to gradually change from the third switching frequency to the N^{th} target switching frequency according to a comparison result, and then return to the third switching frequency from the N^{th} target switching frequency. The N^{th} target switching frequency is between the first switching frequency and the second switching frequency, and is not equal to the third switching frequency. The initial switching frequency may be a randomly generated frequency or a set frequency. The set frequency may be equal to or different from the third switching frequency and is between the first switching frequency and the second switching frequency. N is a natural number starting from 2.

The oscillation circuit 02 is configured to receive a switching frequency digital signal output by the control circuit and convert the same into a clock signal with a determined switching frequency. The control circuit receives the clock signal and adjusts the frequency via linear stepping, and the operations are repeated.

FIG. 7 is a structural block diagram illustrating a control circuit in the switching circuit shown in FIG. 6.

The control circuit 01 includes a linear feedback shift register 01-1 and an adder circuit 02-1. The adder circuit 02-1 includes a comparison unit 02-11, an adder 02-22 and a trigger 02-33.

The linear feedback shift register 01-1 is configured to generate the first pseudo-random number based on a first switching frequency, a second switching frequency and a third switching frequency therebetween, and determine the first target switching frequency for switching frequency adjustment based on the first pseudo-random number; generate an N^{th} pseudo-random number, and determine an N^{th} target switching frequency F_{RN} for switching frequency adjustment based on the N^{th} pseudo-random number.

The adder circuit is configured to compare the first target switching frequency with an initial switching frequency, and compare the N^{th} target switching frequency with the third switching frequency; and
configured to adjust the switching frequency to gradually change from the initial switching frequency to the first target switching frequency according to a comparison result; and configured to adjust the switching frequency to gradually change from an (N-1)^{th} target switching frequency to the N^{th} target switching frequency.

The comparison unit 02-11 is configured to compare the first target switching frequency with the initial switching frequency, and compare the N^{th} target switching frequency with the third switching frequency. The comparison unit 02-11 inputs a comparison result to the adder 02-22.

When the first target switching frequency is less than the initial switching frequency, the adder 02-22 gradually deceases the switching frequency from the initial switching frequency to the first target switching frequency or the first switching frequency by a pseudo-random number. A greater one of the first target switching frequency or the first switching frequency is taken as a target switching frequency for switching frequency adjustment. When the first target switching frequency is greater than the third switching frequency, the adder 02-22 gradually increases the switching frequency from the initial switching frequency to the first target switching frequency or the second switching frequency by the pseudo-random number. A smaller one of the first target switching frequency or the second switching frequency is taken as the target switching frequency for switching frequency adjustment.

When the N^{th} target switching frequency is less than the third switching frequency, the adder 02-22 gradually decreases the switching frequency from the third switching frequency to the N^{th} target switching frequency or the first switching frequency by a pseudo-random number. A greater one of the N^{th} target switching frequency or the first switching frequency is taken as a target switching frequency for switching frequency adjustment. When the N^{th} target switching frequency is greater than the third switching frequency, the adder 02-22 gradually increases the switching frequency from the third switching frequency to the N^{th} target switching frequency or the second switching frequency by the pseudo-random number. A smaller one of the N^{th} target switching frequency or the second switching frequency is taken as the target switching frequency for switching frequency adjustment. The adjusted switching frequency F_{SET} is processed by the adder 02-22 to obtain a switching frequency F_{SET_NEXT}, which then passes through the trigger 02-33. Such operations are repeated until the target switching frequency is reached.

This switching circuit implements the switching frequency dithering and optimizes comprehensive system performance such as improving system efficiency, reducing noise and ripple, suppressing switching harmonics, and reducing electromagnetic radiation.

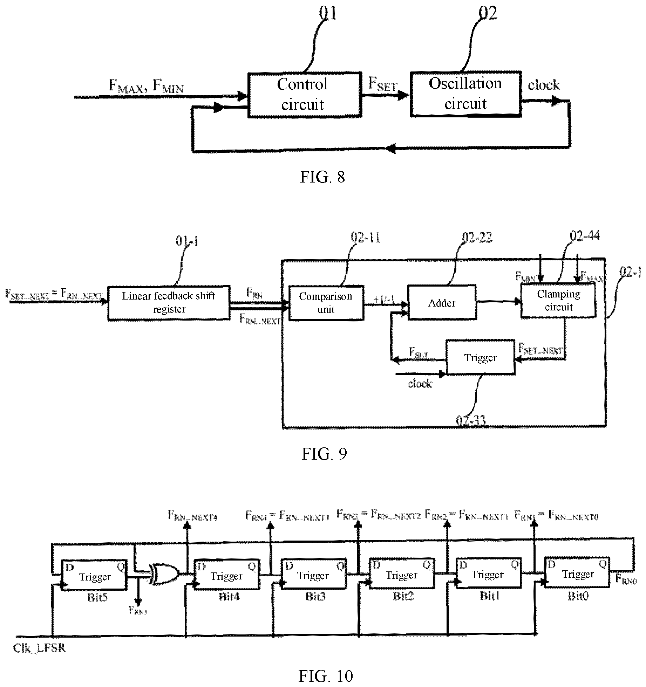

According to a fourth aspect, FIG. 8 is a structural block diagram illustrating a switching circuit disclosed in an embodiment of the present application.

The switching circuit in this embodiment shown in FIG. 8 is the same as the switching circuit shown in FIG. 6 except a control circuit part. The switching circuit disclosed in the embodiment of the present application is configured to control a clock frequency change and includes a control circuit 01 and an oscillation circuit 02. The control circuit 01 is connected to the oscillation circuit 02.

The control circuit 01 is configured to set a first switching frequency and a second switching frequency;
configured to: set an initial switching frequency and generate the first pseudo-random number at the beginning of a series of clock cycles; determine the first target switching frequency for switching frequency adjustment based on the first pseudo-random number, and adjust the switching frequency to gradually change from the initial switching frequency to the first target switching frequency;
configured to generate an N^{th} pseudo-random number, and determine an N^{th} target switching frequency for switching frequency adjustment based on the N^{th} pseudo-random number;
configured to compare the N^{th} target switching frequency with an (N-1)^{th} target switching frequency, where the (N-1)^{th} target switching frequency is determined by an (N-1)^{th} pseudo-random number generated randomly; and
configured to adjust the switching frequency to gradually change from the (N-1)^{th} target switching frequency to the N^{th} target switching frequency according to a comparison result, where the (N-1)^{th} target switching frequency and the N^{th} target switching frequency are between the first switching frequency and the second switching frequency, the initial switching frequency may be a randomly generated frequency or a set frequency, the set frequency is between the first switching frequency and the second switching frequency, and N is a natural number starting from 2.

The oscillation circuit 02 is configured to receive a switching frequency digital signal output by the control circuit and convert the same into a clock signal with a determined switching frequency. The control circuit receives a clock signal input and adjusts the frequency via linear stepping, and the operations are repeated.

FIG. 9 is a structural block diagram illustrating a control circuit part in the switching circuit shown in FIG. 8.

The control circuit part in this embodiment shown in FIG. 9 is the same as the control circuit part shown in FIG. 7 except that a clamping circuit 02-44 is added to the adder circuit 02-1.

The control circuit 01 includes a linear feedback shift register 01-1 and an adder circuit 02-1. The adder circuit 02-1 includes a comparison unit 02-11, an adder 02-22, a trigger 02-33 and the clamping circuit 02-44.

The linear feedback shift register 01-1 is configured to generate the first pseudo-random number, and determine the first target switching frequency for switching frequency adjustment based on the first pseudo-random number; and
configured to generate an N^{th} pseudo-random number, and determine an N^{th} target switching frequency for switching frequency adjustment based on the N^{th} pseudo-random number.

The comparison unit 02-11 is configured to compare the first target switching frequency with an initial switching frequency, and compare the N^{th} target switching frequency with an (N-1)^{th} target switching frequency. The (N-1)^{th} target switching frequency is determined by a randomly generated (N-1)^{th} pseudo-random number. The comparison unit 02-11 inputs a comparison result to the adder 02-22, and N is a natural number starting from 2.

When the first target switching frequency is less than the initial switching frequency, the adder 02-22 gradually decreases the switching frequency from the initial switching frequency to the first target switching frequency by a pseudo-random number. When the first target switching frequency is greater than the initial switching frequency, the adder 02-22 gradually increases the switching frequency from the initial switching frequency to the first target switching frequency by the pseudo-random number.

When the N^{th} target switching frequency is less than the (N-1)^{th} target switching frequency, the adder 02-22 decreases the switching frequency from the (N-1)^{th} target switching frequency to the N^{th} target switching frequency by a pseudo-random number. When the N^{th} target switching frequency is greater than the (N-1)^{th} target switching frequency, the adder 02-22 increases the switching frequency from the (N-1)^{th} target switching frequency to the N^{th} target switching frequency by the pseudo-random number. The adjusted switching frequency F_{SET} passes through the clamping circuit 02-44 and the trigger 02-33, and then reaches the next switching frequency F_{SET}__{NEXT} through the adder 02-22. Such operations are repeated until the target switching frequency is reached. The clamping circuit 02-44 is arranged between an output end of the adder 02-22 and an input end of the trigger 02-33 to control the generated switching frequency to be between the first switching frequency and the second switching frequency.

This switching circuit implements the switching frequency dithering and optimizes comprehensive system performance such as improving system efficiency, reducing noise and ripple, suppressing switching harmonics, and reducing electromagnetic radiation. Therefore, while the conversion efficiency of the switching circuit is improved, the noise and the ripple are reduced, the harmonics are suppressed, the electromagnetic radiation is reduced, and the comprehensive performance of the switching circuit is effectively improved.

FIG. 10 is a schematic diagram illustrating a pseudo-random binary sequence generated by a linear feedback shift register according to an embodiment of the present application. The switching frequency dithering method, the switching circuit and the DC-DC converter using the switching frequency dithering method, and the switching circuit according to the embodiments of the present application all need to generate the switching frequency according to the pseudo-random binary sequence generated by the linear feedback shift register.

According to a fifth aspect, an embodiment of the present application discloses a DC-DC converter. The DC-DC converter includes the switching circuit disclosed in the third aspect or the fourth aspect.

The DC-DC converter according to the embodiment of the present application is configured to transmit a clock signal, and optimizes comprehensive system performance such as improving system efficiency, reducing noise and ripple, suppressing switching harmonics, and reducing electromagnetic radiation.

The DC-DC converter according to the embodiment of the present application may be used in intelligent hardware, such as smart phones.

The above descriptions are merely embodiments of the present application and are not intended to limit the present application. A person skilled in the art can make various modifications and changes to the present application. Any modifications, equivalent replacements, improvements, etc. made within the spirit and principle of the present application shall fall within the protection scope of the claims of the present application.

## Claims

1. A switching frequency dithering method, wherein the dithering method is used to control a clock frequency change and comprises:
setting a first switching frequency, a second switching frequency and a third switching frequency therebetween;
setting an initial switching frequency and generating the first pseudo-random number at the beginning of a series of clock cycles; determining the first target switching frequency for switching frequency adjustment based on the first pseudo-random number, and adjusting the switching frequency to gradually change from the initial switching frequency to the first target switching frequency, and then gradually change from the first target switching frequency to the third switching frequency;
generating an N^{th} pseudo-random number, and determining an N^{th} target switching frequency for switching frequency adjustment based on the N^{th} pseudo-random number;
comparing the N^{th} target switching frequency with the third switching frequency; and
adjusting the switching frequency to gradually change from the third switching frequency to the N^{th} target switching frequency according to a comparison result, and then gradually change from the N^{th} target switching frequency to the third switching frequency, wherein the first target switching frequency and the N^{th} target switching frequency are between the first switching frequency and the second switching frequency, and are not equal to the third switching frequency, wherein N is a natural number starting from 2.

2. The switching frequency dithering method according to claim 1, wherein the initial switching frequency is the same as or different from the third switching frequency.

3. The switching frequency dithering method according to claim 1, wherein the third switching frequency is located at the frequency center position between the first switching frequency and the second switching frequency.

4. The switching frequency dithering method according to claim 1, wherein the switching frequency is adjusted via linear stepping.

5. The switching frequency dithering method according to claim 1, wherein the N^{th} target switching frequency is obtained by gradually increasing or decreasing from the third switching frequency by the pseudo-random number.

6. A switching frequency dithering method, wherein the dithering method is used to control a clock frequency change and comprises:
setting a first switching frequency and a second switching frequency;
setting an initial switching frequency and generating the first pseudo-random number at the beginning of a series of clock cycles; determining the first target switching frequency for switching frequency adjustment based on the first pseudo-random number, and adjusting the switching frequency to gradually change from the initial switching frequency to the first target switching frequency;
generating an N^{th} pseudo-random number, and determining an N^{th} target switching frequency for switching frequency adjustment based on the N^{th} pseudo-random number;
comparing the N^{th} target switching frequency with an (N-1)^{th} target switching frequency, wherein the (N-1)^{th} target switching frequency is determined by an (N-1)^{th} pseudo-random number generated randomly; and
adjusting the switching frequency to gradually change from the (N-1)^{th} target switching frequency to the N^{th} target switching frequency according to a comparison result, wherein the (N-1)^{th} target switching frequency and the N^{th} target switching frequency are between the first switching frequency and the second switching frequency, and N is a natural number starting from 2.

7. The switching frequency dithering method according to claim 6, wherein the switching frequency is adjusted via linear stepping.

8. The switching frequency dithering method according to claim 6, wherein the N^{th} target switching frequency is obtained by increasing or decreasing from the (N-1)^{th} target switching frequency by the pseudo-random number.

9. A switching circuit, wherein the circuit is configured to control a clock frequency change and comprises a control circuit and an oscillation circuit; wherein
the control circuit is configured to set a first switching frequency, a second switching frequency and a third switching frequency therebetween;
set an initial switching frequency and generate the first pseudo-random number at the beginning of a series of clock cycles; determine the first target switching frequency for switching frequency adjustment based on the first pseudo-random number, and adjust the switching frequency to gradually change from the initial switching frequency to the first target switching frequency, and then gradually change from the first target switching frequency to the third switching frequency;
configured to generate an N^{th} pseudo-random number, and determine an N^{th} target switching frequency for switching frequency adjustment based on the N^{th} pseudo-random number;
configured to compare the N^{th} target switching frequency with the third switching frequency; and
configured to adjust the switching frequency to gradually change from the third switching frequency to the N^{th} target switching frequency according to a comparison result, and then gradually change from the N^{th} target switching frequency to the third switching frequency, wherein the first target switching frequency and the N^{th} target switching frequency are between the first switching frequency and the second switching frequency, and are not equal to the third switching frequency, wherein N is a natural number starting from 2; and
the oscillation circuit is configured to receive a switching frequency digital signal output by the control circuit and convert the same into a clock signal with a determined switching frequency.

10. The switching circuit according to claim 9, wherein the control circuit comprises a linear feedback shift register and an adder circuit;
the linear feedback shift register is configured to generate the first pseudo-random number, and determine the first target switching frequency for switching frequency adjustment based on the first pseudo-random number; and
configured to generate the N^{th} pseudo-random number, and determine the N^{th} target switching frequency for switching frequency adjustment based on the N^{th} pseudo-random number; and
the adder circuit is configured to compare the first target switching frequency with the initial switching frequency, and compare the N^{th} target switching frequency with the third switching frequency; and
configured to adjust the switching frequency to gradually change from the initial switching frequency to the first target switching frequency according to a comparison result, and then gradually change from the first target switching frequency to the third switching frequency; and configured to adjust the switching frequency to gradually change from the third switching frequency to the N^{th} target switching frequency, and then change from the N^{th} target switching frequency to the third switching frequency.

11. A switching circuit, wherein the circuit is configured to control a clock frequency change and comprises a control circuit and an oscillation circuit; wherein
the control circuit is configured to set a first switching frequency and a second switching frequency;
configured to: set an initial switching frequency and generate the first pseudo-random number at the beginning of a series of clock cycles; determine the first target switching frequency for switching frequency adjustment based on the first pseudo-random number, and adjust the switching frequency to gradually change from the initial switching frequency to the first target switching frequency;
configured to generate an N^{th} pseudo-random number, and determine an N^{th} target switching frequency for switching frequency adjustment based on the N^{th} pseudo-random number;
configured to compare the N^{th} target switching frequency with an (N-1)^{th} target switching frequency, wherein the (N-1)^{th} target switching frequency is determined by an (N-1)^{th} pseudo-random number generated randomly; and
configured to adjust the switching frequency to gradually change from the (N-1)^{th} target switching frequency to the N^{th} target switching frequency according to a comparison result, wherein the (N-1)^{th} target switching frequency and the N^{th} target switching frequency are between the first switching frequency and the second switching frequency, and N is a natural number starting from 2; and
the oscillation circuit is configured to receive a switching frequency digital signal output by the control circuit and convert the same into a clock signal with a determined switching frequency.

12. The switching circuit according to claim 11, wherein the control circuit comprises a linear feedback shift register and an adder circuit;
the linear feedback shift register is configured to generate the first pseudo-random number, and determine the first target switching frequency for switching frequency adjustment based on the first pseudo-random number; and
configured to generate the N^{th} pseudo-random number, and determine the N^{th} target switching frequency for switching frequency adjustment based on the N^{th} pseudo-random number; and
the adder circuit is configured to compare the first target switching frequency with the initial switching frequency, and compare the N^{th} target switching frequency with the (N-1)^{th} target switching frequency; and
configured to adjust the switching frequency to gradually change from the initial switching frequency to the first target switching frequency according to a comparison result; and configured to adjust the switching frequency to gradually change from the (N-1)^{th} target switching frequency to the N^{th} target switching frequency.

13. A DC-DC converter, comprising the switching circuit according to any one of claims 9 and 10 or the switching circuit according to any one of claims 11 and 12.
